Europäisches Patentamt

European Patent Office

Office européen des brevets

(19)

(11) Publication number: **0 186 854 B1**

# EUROPEAN PATENT SPECIFICATION

(12)

(45) Date of publication of patent specification: **01.04.92** (51) Int. Cl.5: **H03L 7/18**

(21) Application number: **85116125.7**

(22) Date of filing: **18.12.85**

(54) **Frequency synthesizer having means for suppressing frequency instability caused by intermittent PLL operation.**

(30) Priority: **28.12.84 JP 276319/84**

(43) Date of publication of application:
**09.07.86 Bulletin 86/28**

(45) Publication of the grant of the patent:
**01.04.92 Bulletin 92/14**

(84) Designated Contracting States:
**DE FR GB IT NL**

(56) References cited:
**EP-A- 0 051 774**
**DE-A- 1 591 621**
**DE-A- 3 122 274**
**GB-A- 2 107 142**
**US-A- 3 164 777**

(73) Proprietor: **FUJITSU LIMITED**
**1015, Kamikodanaka Nakahara-ku**
**Kawasaki-shi Kanagawa 211(JP)**

(72) Inventor: **Itaya, Eiji**
**613-9, Iwase**
**Kamakura-shi Kanagawa 247(JP)**
Inventor: **Takano, Takeshi**
**1271-362, Ushiku Ushikumachi**
**Inashiki-gun Ibaragi, 300-12(JP)**
Inventor: **Nakamura, Takaharu**
**1189, Tajima**
**Urawa-shi Saitama 336(JP)**

(74) Representative: **Eitle, Werner, Dipl.-Ing. et al**
**Hoffmann, Eitle & Partner Patentanwälte Arabellastrasse 4**
**W-8000 München 81(DE)**

**Description**

The present invention relates to a frequency synthesizer circuit for use in a mobile transmission system, and

having a phase locked loop (PLL) for intermittent operation comprising:

a reference frequency generating means for generating a reference frequency ($f_r$);

a phase locked loop (PLL) circuit, which comprises a voltage controlled oscillator (5) for providing an output frequency ($f_{out}$);

a frequency divider means for dividing said output frequency by an integer and for providing a comparison frequency ($f_p$) which is close to said reference frequency ($f_r$);

a phase comparator for providing a difference signal corresponding to phase difference between the reference frequency ($f_r$) and comparison frequency ($f_p$);

a loop filter for receiving said difference signal and for providing a control signal to control the output frequency of said VCO; and

a power switch (Sp) for switching on or off a power supply to said frequency divider means for making it operate intermittently.

Such a circuit is known from EP-A-0051774.

Phase-locked loop (PLL) type frequency synthesis is widely used for stabilising frequency generators, and can provide various frequencies having predetermined frequency intervals between each other. It is especially used to provide a local oscillator in mobile communication systems which need to shift the receiving frequency sequentially to find an idle channel allotted to the area where the receiver is located.

In such mobile system, it is important to save the battery or power consumption. The power of the frequency synthesizer is consumed mainly in the PLL circuit, because the PLL circuit comprises bipolar transistor elements which consume high current in order to operate in a very high frequency, while other circuits can be composed of FET (field effect transistor) elements whose power consumption is very low. Therefore, the PLL circuit is generally operated intermittently to save its power consumption. On the other hand the frequency stability of such frequency synthesizer is required to be very high, because the frequencies allotted for mobile systems are very closely spaced. Thus a very small jittering or fluctuation of frequency causes malfunction of the system.

In order to make clear the problem of prior art frequency synthesizers and to clarify the advantage of the present invention, a known circuit arrangement for a frequency synthesizer and its operation will be described briefly.

The frequency synthesizers generally utilize a phase-locked loop (PLL) including a voltage controlled oscillator (VCO), a reference oscillator, and a phase detector for comparing the output of the VCO with a reference frequency. Normally, a prescaling frequency counter and at least one programmable or switchable frequency divider is included within the PLL so that the loop can be locked to various multiples of the reference source frequency.

The prescaling counter (called prescaler) counts down the frequency of the VCO which is the output frequency of the synthesizer (usually a very high frequency) to a lower frequency in order to deal with it by low speed IC (integrated circuit) devices.

If the frequency of the reference oscillator is $f_r$, the count down ratio of the prescaler and the programmable frequency divider are 1/P and 1/N respectively, the output frequency $f_{out}$ becomes

$$f_{out} = N \cdot P \cdot f_r$$

Accordingly, the output frequency becomes an integral multiple of the reference frequency $f_r$ which is stabilized with crystal oscillator. Thus, it is possible to provide a frequency stable signal at any one of a plurality of frequencies separated by $f_r$ without the need of a crystal for each such frequency. Such method is referred to as the prescaling method, and there are several modifications of such prescaling method, such as the pulse swallow method for example. They are disclosed in for example, "Frequency Synthesizers Theory and Design" by Vadio Manassewitsch, 1976, John Wiley & Sons Inc.

More details of such frequency synthesizers are given in, for example, U.S. Patent 4,521,918 Jun. 4, 1985 by R. F. Challen, which discloses a fundamental of the frequency synthesizer, Japanese Laid Open Patents Provisional No. 58-159029 by Nishiki et al, No. 58-66422 by Ohba et al, or No. 58-66423 by Fujita et al. They all refer to power saving in the PLL circuit by operating it intermittently. Most of the power is consumed by bipolar devices included in the PLL circuit, especially the prescaling circuit which is operated at a very high frequency. Thus, though it is a very short time, there appears an instant during which the output frequency of the frequency synthesizer becomes unstable corresponding to the starting up of the frequency counter when the PLL circuit is switched ON and OFF. Owing to such frequency instability, many of the mobile communication systems are required to provide some means to prevent malfunctions due to such frequency instability.

SUMMARY OF THE INVENTION

The object of the present invention, therefore, is to provide a frequency synthesizer whose frequency instability due to intermittent operation of the PLL circuit is suppressed.

Another object of the present invention is to provide a frequency synthesizer applicable to mobile transmission systems without creating a problem caused by frequency instability.

According to the present invention, the frequency synthesizer initially defined is characterized by:

a first switch provided between said reference frequency oscillator and one input terminal of said phase comparator;

a second switch provided between said frequency divider means and another input terminal of said phase comparator; and

means for controlling ON-OFF timing of said power switch, said first switch and said second switch so that at a time when said power switch is in the ON state the reference frequency and the comparison frequency are applied to said phase comparator with equalized phases.

Other objects and advantages of the present invention will become apparent from the detailed description to follow taken in conjunction with the accompanying drawings in which:

Fig. 1 is a block diagram of an exemplary frequency synthesizer circuit of prescaling type.

Fig. 2 shows a relation between the ON-OFF timing of the PLL circuit and the fluctuation of output frequency of the frequency synthesizer, wherein:

(A) is a diagram showing the ON-OFF timing of the PLL circuit; and

(B) illustrates schematically the frequency fluctuation of the frequency synthesizer.

Fig. 3 is a time chart illustrating phase relationship between various parts of intermittently operated PLL circuit, wherein:

(A) shows a waveform of a reference oscillator;

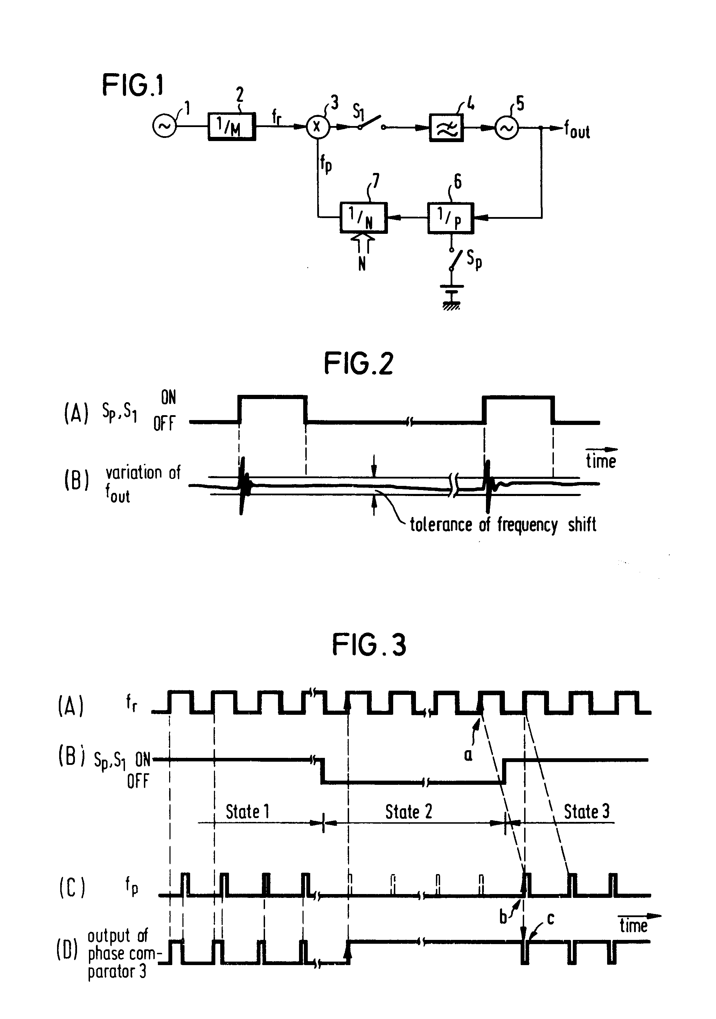

(B) shows ON-OFF timing of the switches S1 and Sp of Fig. 1;

(C) shows the phase of the output signal fp of a programmable frequency divider ; and

(D) shows the output of a phase comparator.

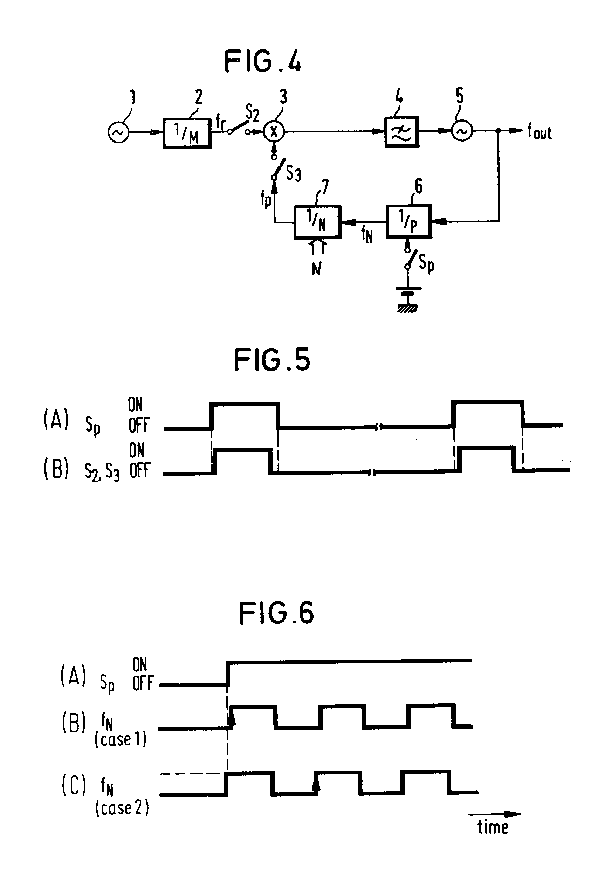

Fig. 4 shows a block diagram for a first embodiment of a frequency synthesizer according to the present invention.

Fig. 5 is a time chart illustrating the ON-OFF timing of switches in Fig. 4, wherein

(A) shows the timing of the switch Sp; and

(B) shows the timing of the switches S2 and S3.

Fig. 6 is a time chart to explain the start of counting operation of a 1/N programmable frequency divider.

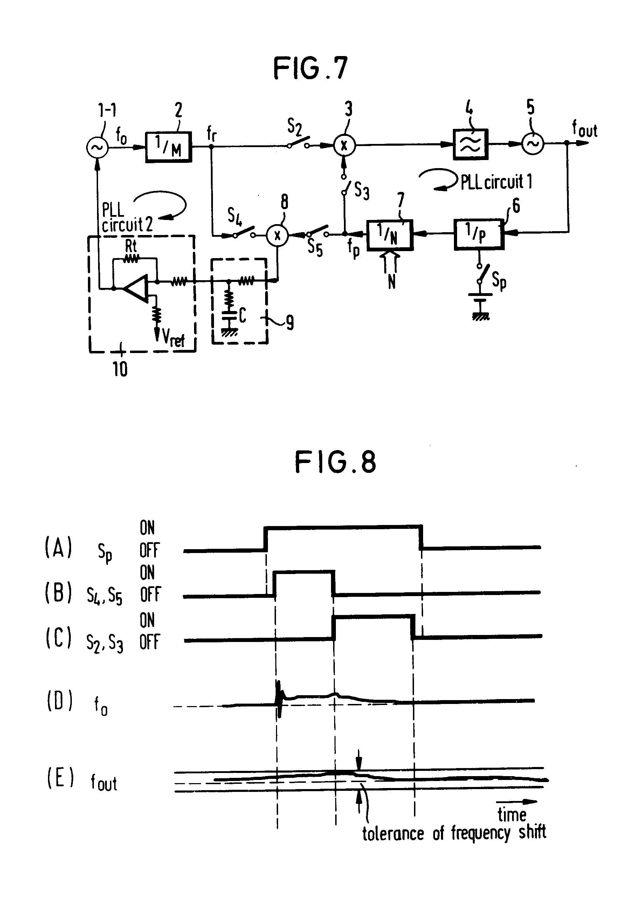

Fig. 7 shows a block diagram for a second embodiment of the present invention.

Fig. 8 is a time chart illustrating ON-OFF timing at various parts of the circuit of Fig. 7, and variation of output frequency $f_{out}$ corresponding to these times.

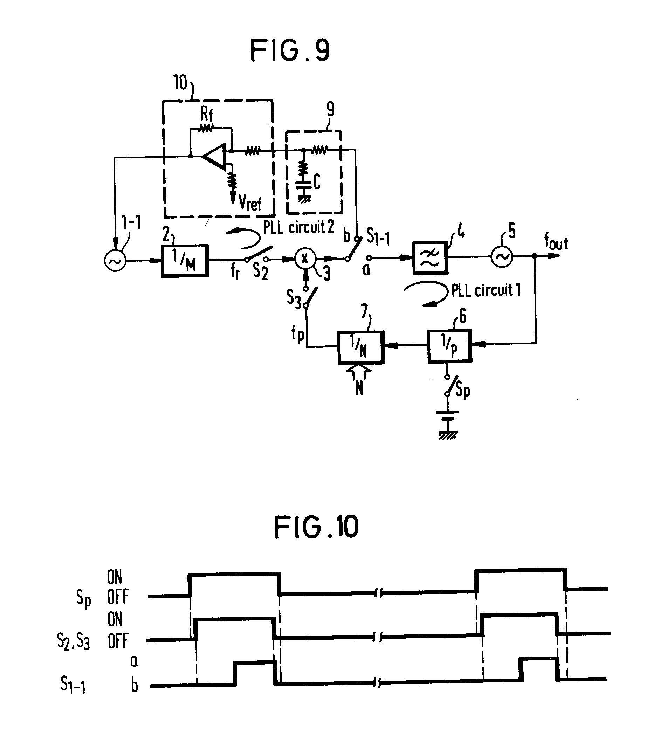

Fig. 9 shows a block diagram for a third embodiment of the present invention.

Fig. 10 is a time chart illustrating ON-OFF timing at various parts of the circuit of Fig. 9.

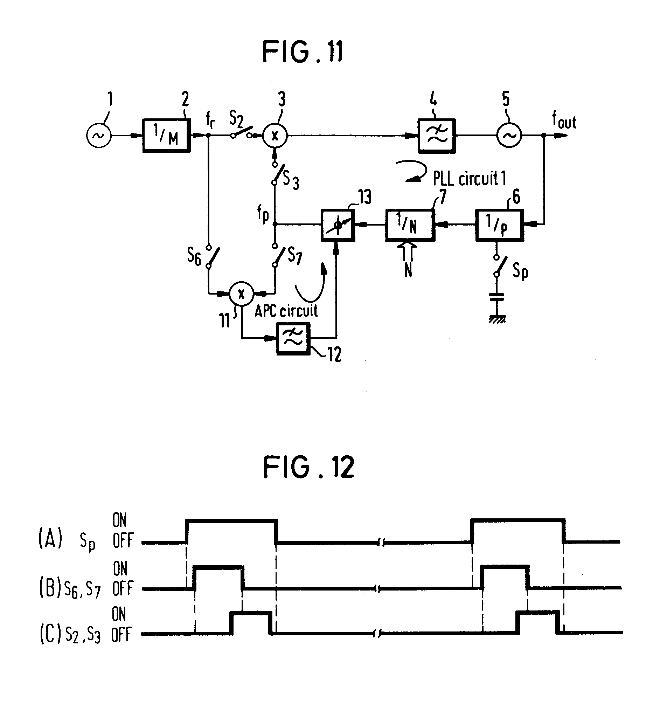

Fig. 11 shows a block diagram for a fourth embodiment of the present invention.

Fig. 12 is a time chart illustrating ON-OFF timing at various parts of the circuit of Fig. 11.

Same or like reference numerals designate same or corresponding parts through the drawings.

The problem of frequency instability mentioned above has now been analyzed by the inventors. It has been found that instability occurs at each instant when the PLL is switched on. The analysis shows that the frequency instability is a kind of frequency ringing of the PLL circuit, caused by an uncertainty of phase relationship between the switch-on time and that of the reference frequency. The analysis will be disclosed in detail hereinafter.

Depending on the above-mentioned analysis, two switches are inserted on each of two sides of the phase comparator of the PLL circuit, and are rendered ON or OFF simultaneously whilst the power switch for the prescaler is ON. Namely, the above two switches are switched on after the power switch becomes ON, and switched off before the power switch becomes OFF. By doing so, the output of the phase comparator has a high impedance while above two switches are OFF, so a voltage stored in the loop filter retains its value and the VCO keeps its frequency determined while the PLL is ON. When the two switches are switched on there appears no frequency ringing, since the phase relationship between the switching time and the reference frequency is kept constant.

The reason why such frequency instability occurs when the PLL is operated intermittently will be explained. Fig. 1 is a block diagram showing an exemplary frequency synthesizer of prescaling type. In the figure, 1 is a crystal stabilized oscillator of about 10 MHz for example, 2 is a frequency divider which divides the frequency of the oscillator 1 by M to provide a reference frequency $f_r$ (30 kHz for example). The phase-locked loop (PLL) comprises a phase comparator 3, a low pass filter 4, a voltage controlled oscillator (VCO) 5, a prescaler 6 and a variable (or switchable) frequency divider 7. The output frequency $f_{out}$ (about 800 MHz for example) of the VCO 5 is controlled by a signal supplied from a low pass filter 4 which is referred to as a loop filter. The output frequency $f_{out}$ is divided by a prescaler 6 which has a division ratio of 1/P (1/128 for example), so the frequency is divided to about 6 MHz which is enough to be processed by FET devices. The output of the prescaler 6 is fed to the programmable frequency divider 7 having a variable division ratio 1/N, and further converted to a lower frequency $f_p$, which is almost equal to $f_r$.

The phase of the $f_p$ is compared with that of $f_r$ by the phase comparator 3 and fed back to the VCO 5 through the loop filter 4. Thus the output frequency $f_{out}$ is stabilized to N $\cdot$ P $\cdot$ $f_r$. By varying the integer N $\cdot$ P $\cdot$, it is possible to obtain a stabilized frequency at an integral multiple of the reference frequency $f_r$.

In order to save the power consumption of the PLL circuit, switches S1 and Sp are provided in the PLL circuit and controlled to be simultaneously ON and OFF as shown in diagram (A) of Fig. 2, to make the PLL circuit operate intermittently. These switches S1 and Sp and those which will be described hereinafter are composed by FETs. The switch Sp controls the power supply to the prescaler 6. While the switches S1 and Sp are ON, the output frequency is clamped exactly to N $\cdot$ P $\cdot$ $f_r$. When the switches S1 and Sp are OFF, the output frequency does not drift so much, since the output voltage of the loop filter 4 is stored in its capacitor (not shown). So, most of frequency synthesizer used for mobile system utilize such a battery saving mechanism. And most of the development efforts seems to have been directed to the power saving of the PLL circuit.

But trouble occurs at the instance of ON-OFF switching of the PLL circuit. Namely, at each time of the beginning of ON state the output frequency $f_{out}$ becomes unstable as illustrated schematically by curve (B) in Fig. 2. The reason is considered to be as follows.

Let phase of the reference frequency $f_r$ and the output frequency $f_p$ of the programmable frequency divider 7 be respectively as shown in diagram (A) and (C) of Fig. 3, which is a time chart illustrating phase relationship between various parts of intermittently operated PLL circuit as shown in Fig. 1. During the time when the switches Sp and S1 are ON as shown by a diagram (B), the output of the phase comparator 3 will as shown by a diagram (D). Such state will be referred to as state 1, as illustrated in diagram (B).

During state 1, the phase comparator 3 outputs a signal corresponding to the phase difference between $f_r$ and $f_p$ as illustrated in the diagram (D), and such signal is supplied to the VCO via the low pass filter 4. So the VCO is controlled by this signal and the output frequency $f_{out}$ and hence $f_p$ is corrected and clamped to $N \cdot P \cdot f_r$. In the diagram (D) it is illustrated that the phase of $f_p$ is corrected and the output signal of the comparator 3 decreases to zero.

The state where the switches Sp and S1 are switched off, will be referred to as state 2. In this state, the signal $f_p$ disappears as shown in diagram (C). So, the phase comparator 3 judges that the phase of $f_p$ is delayed more than $2\pi$ radian, and the output of the phase comparator 3 becomes a constant as shown in the diagram (D). But since the switch S1 becomes OFF simultaneously, the VCO continues to output the frequency which is clamped during the state 1, since the input to the low pass filter 4 is cut off, and the control voltage of the VCO 5 is retained in a capacitor (not shown) of the low pass filter 4. During the state 2, the drifting of the output frequency will occur. But normally it is very small and the duration of the OFF state is designed properly (for example 1 sec) to avoid that much frequency drifting occurs.

After the state 2, the switches Sp and S1 are switched on again, as illustrated in Fig. 3. This will be referred to as state 3. At this time, it should be pointed out that the diagrams of Fig. 3 are illustrating a condition that the frequency drifting during the state 2 is zero, that means that $f_p$ is kept perfectly in phase with $f_r$ ($f_p$ is clamped to $f_r$ at the end of state 1). Therefore, at the starting time of the state 3, the output signal of the phase comparator should be zero. But since the switching time of the switches Sp and S1 are not synchronized to $f_r$, the switching may occur at a point between the point a and b designated in the diagrams (A) and (C) of Fig. 3. In the case illustrated in Fig. 3, accordingly, the output of the phase comparator 3 becomes as illustrated in diagram (D). Namely, at the instant when the switches Sp and S1 become ON, the output of the phase comparator attains a value shown by c in the diagram (D). So, the VCO begins to follow this signal and causes so called frequency ringing, but it is quenched rapidly by the PLL action as shown in the curve in Fig. 2 (B).

The frequency ringing as described above occurs at each time when Sp and S1 are switched on. It will be understandable for one skilled in the art that the amplitude of the frequency fluctuation depends on the phase difference between $f_r$ and switch on time of Sp, so it is quite irregular. But it will be understood that the maximum amplitude corresponds to the maximum phase difference $2\pi$ of $f_r$. When the fluctuation exceeds the tolerance of the frequency stability, the system suffers from malfunctioning.

Now, a method to suppress such frequency instability in the frequency synthesizer will be disclosed with respect to some preferred embodiments of the present invention. Fig. 4 shows a block diagram for a first embodiment of the present invention. Throughout the drawings hereinafter, same or like reference numerals designate same or corresponding parts. Comparing the circuit of Fig. 4 to that of Fig. 1, switch S1 has been eliminated but new switches S2 and S3 are provided on each of the two inputs of the phase comparator 3. These switches S2 and S3 control simultaneously $f_r$ the input to the phase comparator 3 of the reference frequency and $f_p$ the output frequency of programmable frequency divider 7 respectively. And the ON-OFF timing of these switches are controlled so that S2 and S3 are switched on or off while the power control switch Sp is in ON state.

Fig. 5 shows the timing relationship of these switches. As can be seen in the Figure, the switches S2 and S3 are switched simultaneously, but they are switched on a little later (5 ms for example) than the switch Sp is switched on, and they are switched off a little before (5 ms for example) switch Sp is switched off. Such timing control is not so severe, so it can be controlled by ordinary control means.

By doing so, when the S2 and S3 are switched off, the inputs to the phase comparator 3 are cut off and the output voltage of the phase comparator becomes zero, at the same time the output impedance of conventional phase comparator (which are supplied from various vendors as an IC) becomes very high, so the control voltage for the VCO 5 is retained in the capacitor (not shown) in the low pass filter 4 (which is also conventional one). So, the VCO 5 continues to provide the output frequency $f_{out}$ which is determined at the end of ON state of the phase comparator 3.

In the circuit of Fig. 4, when the switches S2 and S3 are switched on again, the problem of phase relationship between $f_r$ and $f_p$ that has been described with respect to Fig. 3 does not occur, because S2 and S3 are switched on simultaneously after Sp is switched on. This will be understood from the following considerations. As has been described with respect to Fig. 3, usually the output of the phase comparator 3 is zero at the end of the state 1, since $f_p$ has been locked to $f_r$. Therefore, if it is assumed that $f_p$ is kept equal to $f_r$ during the time when the PLL is switched off, the output of the phase comparator 3 is zero when S2 and S3 are switched on again, therefore, no frequency instability occurs. If frequency variation occurs while S2 and S3 are OFF, the PLL starts its normal operation to stabilize the frequency when S2 and S3 are switched on.

Like a manner described above, the frequency instability in the frequency synthesizer has been suppressed to a greater extent by the circuit of Fig. 4. But it has been found that the frequency instability still occurs in the circuit of Fig. 4, though the amplitude of frequency fluctuation is very small compared to that of prior art circuits of Fig. 1 for example. This frequency instability has been analyzed and found that it is due to the phase uncertainty of the timing when the switch Sp becomes ON against the phase of $f_N$ the input signal to the 1/N variable frequency divider 7.

The reason can be explained as follows. Fig. 6 is a time chart showing the phase relationship between the switch Sp and $f_N$ the input frequency of 1/N variable frequency divider 7. Since the switch Sp is not synchronized to $f_N$, the start of a frequency counter in the frequency demultiplexer 7 has no relationship to the timing when the switch Sp become ON. So, if the counter starts just after Sp became ON as a case 1 shown in diagram (B), phase delay is almost zero. But if the counter starts to count $f_N$ a little earlier than the above case as a case 2 shown in diagram (C), the phase delay becomes maximum ($2\pi$). Such phase difference occurs regardless of the relationship between the switching time of Sp so long as Sp is not synchronized to $f_N$. Though such phase difference is reduce to 1/N at the input of the phase comparator 3 by the operation of the 1/N programmable frequency divider 7, it causes similar frequency instability as has been described with respect to Figs. 2 and 3, though its amplitude is very small.

The embodiments shown in Figs. 7, 9 and 11 are designed to suppress such minor frequency instability described above. Fig. 7 is a block diagram for a second embodiment of frequency synthesizer by the present invention. Compared to the circuit of Fig. 4, the circuit of Fig. 7 further comprises a second PLL circuit which provides the reference frequency $f_r$. The second PLL circuit comprises a voltage controlled crystal oscillator (VCXO) 1-1, a 1/M frequency divider 2, a third switch S4, a second phase comparator 8, a second loop filter 9 and an operational amplifier 10. They are connected to the first (main) PLL circuit through switches S2 and S5. Since the second PLL circuit is operated at a lower frequency, it is composed from FET devices and so its power consumption is very low. The control of these switches can be done by conventional methods, so they are neglected for the sake of simplicity.

In the circuit of Fig. 7, the switch Sp is switched on first. Then a little later (usually few ms later) the switches S4 and S5 are switched on. A time chart for these switches are given by diagrams (A), (B) and (C) of Fig. 8. At this time, if the phase of $f_p$ the output signal of the 1/N division of frequency divider 7 is not equal to that of the reference frequency $f_r$, a voltage corresponding to the difference between them appears from the second phase comparator 8. This voltage is smoothed by the second loop filter 9, amplified by the operational amplifier 10, and fed back to the VCXO 1-1 to adjust the phase.

This phase adjustment is done by varying $f_0$, the oscillation frequency of the VCXO 1-1. Therefore, a frequency instability occurs in $f_0$ caused by a phase uncertainty of $f_r$ against $f_p$ with the same mechanism as has been described with respect to Figs. 1 through 3. The variation of $f_0$ becomes as shown by a curve (D) in Fig. 8. But as can be seen in Fig. 8 (C), the switches S2 and S3 are OFF, so the first PLL is not disturbed by such frequency instability.

The frequency $f_0$ should be essentially a standard frequency, therefore, any frequency shift should not be allowed. But in this case, such anxiety is unnecessary. During the phase adjustment between $f_r$ and $f_p$, the output frequency $f_{out}$ plays the role of standard frequency. As has been described before, $f_{out}$ is kept almost locked to $N \cdot P \cdot f_r$. So, while S2 and S3 are switched off, VCO 5 retains its stability enough to be a standard oscillator. Therefore, $f_0$ is locked against $f_{out}$ as shown by curves (D) and (E).

After the phase of $f_p$ and $f_r$ are equalized (approximately 50 ms later), the switches S4 and S5 are switched off, at the same time the switches S2 and S3 are simultaneously switched on as shown in Fig. 8 (B) and (C). The frequency instability never occurs when the switches S2 and S3 are switched on, since the phase of both inputs of the phase comparator is equalized.

And when the switches S4 and S5 are switched off simultaneously, the output impedance of the second phase comparator 8 becomes high, so the voltage stored in a capacitor C in the second loop filter 9 is discharged slowly to the ground or to the voltage source V (not shown) applied to the operational amplifier 10 through a feed back resistor Rf. In the Figure, Vref represents a reference voltage applied to the operational amplifier. Then the control voltage for the VCXO 1-1 goes back slowly to the initial condition. In such a manner, the output frequency $f_{out}$ is kept within a small tolerance of frequency shift as shown in Fig. 8 (E).

An example of the switching period in Fig. 8 is as follows. The power switch Sp is ON for about 100 ms, and OFF for about 1 sec, so the power consumption is reduced to approximately 1/10 of the continuous operation. During the period of ON time of Sp, the first half period (50 ms for example) is used for the second PLL to equalize the phase of $f_r$ to that of $f_p$, and the later half period (50 ms for example) is used for the first PLL to equalize the phase of $f_p$ to that of $f_r$. These periods are a typical ones, and the other embodiments to follow are operated with almost the same operational periods.

Fig. 9 is a third embodiment of frequency synthesizer by the present invention, and Fig. 10 is a time chart showing the timing of switches used in the circuit. The circuit of Fig. 9 has a second PLL circuit comprising a VCXO 1-1, a 1/M frequency divider 2, a switch S2, a first phase comparator 3 which is used commonly with the first PLL circuit, a circuit changing switch S1-1, a second loop filter 9 and an operational amplifier 10.

As shown in Fig. 10, at first the circuit changing switch S1-1 is switched to a contact b connected to the second loop filter 9, the switch Sp is turned on first. After few ms for example, the switches S2 and S3 are turned on simultaneously, and phase of $f_p$ and $f_r$ are equalized by the second PLL. Then the switch S1-1 is switched from b to a, a terminal connected to the first loop filter 4, and $f_{out}$ is locked to $f_r$. When the phase locking operation is completed, S2 and S3 are switched off at the same time S1-1 is switched back to b. Then Sp is turned off. The frequency instabilities never occur, since phases are always equalized in a similar manner to that described with respect to the circuit of Fig. 7.

Fig. 11 is a fourth embodiment of frequency synthesizer according to the present invention, and Fig. 12 is its time chart. In this embodiment the VCXO is unnecessary and an ordinary crystal oscillator 1 is used. The second PLL circuit has been replaced by an automatic phase control (APC) circuit comprising, a third phase comparator 11, a low pass filter 12, a variable phase shifter 13 and a switch S7. Inputs of the third phase comparator 11 is fed with $f_r$ and $f_p$ through the switches S6 and S7 respectively. The output of the phase comparator 11 is fed back to the variable phase shifter 13 via the low pass filter 12 to control the phase shifter.

As shown in Fig. 12, the power switch Sp is turned on first. After few ms, the switches S6 and S7 are switched on, and the phase difference between $f_r$ and $f_p$ due to the uncertainty of the switch-on time of the programmable frequency divider 7 against $f_r$ are corrected by shifting the phase of $f_p$. When the phase is corrected, S2 and S3 are simultaneously switched on while S6 and S7 are still ON, and the first PLL circuit begins to lock $f_{out}$ by $f_r$. Then the APC circuit is switched off turning S6 and S7 to off. After $f_{out}$ is stabilized by $f_r$, S2 and S3 are turned off, and finally Sp is turned off. Like the other embodiments, the frequency instability is prevented, since the phase of $f_r$ and $f_p$ are equalized.

In the above disclosure, the circuit elements such as crystal oscillator, count-down frequency divider, phase comparator, loop filter, voltage controlled oscillator, phase shifter and various switches are all conventional ones available from various vendors, and most of them are usually fabricated in an IC. So the circuits described above are all able to be composed from these conventional circuit elements. Therefore, above explanation have been limited for the description of the circuit configuration.

As has been described before, the frequency synthesizer utilizing prescaling could not be used in mobile transmission system because of is frequency instability when it is operated intermittently to save its battery consumption. But by applying the present invention, the frequency instability has been suppressed. For example, a prior art frequency synthesizer of Fig. 1 operated in 800 MHz band, had presented a frequency instability like shown in Fig. 2, of which maximum amplitude of frequency shift was about few tens of MHz. But when the circuit of Fig. 4 is applied for the same frequency band, the maximum frequency shift has been decreased to few hundreds of kHz. And the frequency instability has been further suppressed to less than 2 kHz at maximum by applying the circuits of Figs. 7, 9 and 11. At the same time the power consumption has been reduced to approximately one tenth of the continuous operation circuit.

Therefore, the present invention has made it possible to apply the intermittent operated frequency synthesizer to mobile transmission systems. Moreover, application of the frequency synthesizer by the present invention is not limited to a mobile system, it can be applied to any field where a low power consumption and a close frequency allotment is required.

**Claims**

1.  A frequency synthesizer having a phase locked loop (PLL) for intermittent operation comprising:

    a reference frequency generating means (1, 2) for generating a reference frequency ($f_r$);

    a phase locked loop (PLL) circuit, which comprises a voltage controlled oscillator (5) for providing an output frequency ($f_{out}$);

    a frequency divider means (6,7) for dividing said output frequency by an integer and for providing a comparison frequency ($f_p$) which is close to said reference frequency ($f_r$);

    a phase comparator (3) for providing a difference signal corresponding to phase difference between the reference frequency ($f_r$) and comparison frequency ($f_p$);

    a loop filter (4) for receiving said difference signal and for providing a control signal to control the output frequency of said VCO; and

    a power switch (Sp) for switching on or off a power supply to said frequency divider means (6,7) for making it operate intermittently;

    characterized by:

    a first switch (S2) provided between said reference frequency oscillator (2) and one input terminal of said phase comparator (3);

    a second switch (S3) provided between said frequency divider means (6,7) and another input terminal of said phase comparator (3); and

    means for controlling ON-OFF timing of said power switch (Sp), said first switch (S2) and said second switch (S3) so that at a time when said power switch (Sp) is in the ON state the reference frequency ($f_r$) and the comparison frequency ($f_p$) are applied to said phase comparator (3) with equalized phases.

2.  A frequency synthesizer according to claim 1, wherein said first switch (S2) and second switch (S3) are switched on simultaneously after said power switch (Sp) is switched on, and simultaneously switched off before said power switch (Sp) is switched off.

3.  A frequency synthesizer according to claim 1, wherein said reference frequency generating means (2) comprises:

    a crystal stabilized oscillator (1) generating a M multiple of the reference frequency ($f_r$), where M is an integer, and

    a 1/M frequency divider (2) dividing the output frequency of said crystal stabilized oscillator by M.

4.  A frequency synthesizer according to any one of claims 1 to 3, wherein said frequency divider means comprises:

    a prescaler (6) for dividing the output frequency ($f_{out}$) of said VCO (5) by an integer P, input power for said prescaler being switched on or off by said power switch (Sp); and

    a programmable frequency divider (7) for further dividing the output frequency of said prescaler ($f_N$) by a variable integer N.

5.  A frequency synthesizer according to any one of claims 1 to 4, further comprising a second PLL circuit which comprises:

    a second phase comparator (8), for providing a second difference signal corresponding to phase difference between the reference frequency ($f_r$) and said comparison frequency ($f_p$);

    a second filter (9) being a low pass filter connected to receive the second difference signal and to provide a voltage corresponding to the phase difference between the reference frequency ($f_r$) and said comparison frequency ($f_p$);

    an operational amplifier (10) for amplifying said output voltage of second loop filter, and feeding it back to the voltage controlled crystal oscillator means (1-1);

a third switch (S4) inserted between said voltage controlled crystal oscillator means (1-1) and one input terminal of said second phase comparator (8); and

a fourth switch (S5) inserted between another input terminal of said second phase comparator (8) and the output of said frequency divider means (6, 7).

6. A frequency synthesizer according to claim 5, wherein:

said third and fourth switches (S4 and S5) are controllable for simultaneous switch-on after the power switch (Sp) is switched on, and simultaneously switch off while the power switch (Sp) is in the ON state; and

said first and second switches (S2 and S3) are controlled for simultaneous switch-on at the same time that the third and fourth switches are switched off, and simultaneous switch-off while the power switch (Sp) is in the ON state.

7. A frequency synthesizer according to claim 5, wherein said voltage controlled crystal oscillator means comprises:

a voltage controlled crystal oscillator (1-1), for generating an M multiple of the reference frequency ($f_r$), where M is an integer, and

a 1/M frequency divider (2) for dividing the output frequency of said voltage controlled crystal oscillator by M.

8. A frequency synthesizer according to any one of claims 1 to 4, further comprising a second PLL circuit which comprises:

a phase comparator (3) which is commonly used with said first PLL circuit;

a second loop filter (9) being a low pass filter connected to receive the difference signal from said phase comparator (3) and providing a voltage corresponding to the phase difference between said reference frequency ($f_r$) and said comparison frequency ($f_p$);

an operation amplifier (10) for amplifying said output voltage of said second loop filter, and feeding it back to the voltage controlled crystal oscillator means;

a first switch (S2) provided between said voltage controlled crystal oscillator (VCXO) means and one input terminal of said phase comparator (3); and

a circuit-changing switch (S1-1) provided in the output side of phase comparator (3), for switching the output signal of said phase comparator to the first or second loop filter (4 to 9).

9. A frequency synthesizer according to claim 8, wherein:

said first and second switches (S2 and S3) are controllable for switching on and off simultaneously when the power switch (Sp) is in the ON state; and

said circuit changing switch (S1-1) is controllable for switching to the first loop filter (4) when the first and second switches are in the ON state, and switched back to the second loop filter (9) at the same time that the first and second switches are switched off.

10. A frequency synthesizer according to claim 8, wherein said voltage controlled crystal oscillator means comprises:

a voltage controlled crystal oscillator (VCXO) (1-1) for generating an M multiple of the reference frequency ($f_r$), where M is an integer, and

a 1/M frequency divider (2) for dividing the output frequency of said voltage controlled crystal oscillator by M.

11. A frequency synthesizer according to any one of claims 1 to 4, further comprising an automatic phase control (APC) circuit which comprises:

a third phase comparator (11) of which one input terminal is connected to said reference frequency generating means via a fifth switch (S6), and another input terminal is connected, via a sixth switch (S7), to said second switch (S3) at the side opposite to the connection to the first phase comparator (3);

a low pass filter (12) for receiving the output of said third phase comparator and for providing a control signal; and

a variable phase shifter (13) inserted between said frequency divider means and said second switch (S3), said variable phase shifter (13) being controllable by said control signal from said low pass filter (12).

12. A frequency synthesizer according to claim 11, wherein:

said fifth and sixth switches (S6 and S7) are controllable for switching on and off simultaneously when the power switch (Sp) is in the ON state; and

said first and second switches (S2 and S3) are controllable for simultaneous switch-on when the fifth and sixth switches are in the ON state, and simultaneous switch-off after the fifth and sixth switches are switched off but while the power switch (Sp) is still in the ON state.

**Revendications**

1. Un synthétiseur de fréquence comportant une boucle de verrouillage de phase (ou PLL) prévue pour un fonctionnement intermittent, comprenant :

des moyens de génération de fréquence de référence (1, 2) qui sont destinés à générer une fréquence de référence ($f_r$);

un circuit de boucle de verrouillage de phase (PLL) qui comprend un oscillateur commandé par tension (5), destiné à fournir une fréquence de sortie ($f_{out}$);

des moyens diviseurs de fréquence (6, 7) destinés à diviser la fréquence de sortie par un nombre entier, et à fournir une fréquence de comparaison ($f_p$) qui est proche de la fréquence de référence ($f_r$);

un comparateur de phase (3) qui est destiné à fournir un signal de différence correspondant à la différence de phase entre la fréquence de référence ($f_r$) et la fréquence de comparaison ($f_p$);

un filtre de boucle (4) qui est destiné à recevoir le signal de différence et à fournir un signal de commande pour commander la fréquence de sortie de l'oscillateur commandé par tension; et

un interrupteur d'alimentation (Sp) destiné à mettre en fonction ou hors fonction une alimentation des moyens diviseurs de fréquence (6, 7), pour les faire fonctionner par intermittence;

caractérisé par :

un premier interrupteur (S2) connecté entre l'oscillateur de fréquence de référence (2) et une borne d'entrée du comparateur de phase (3);

un second interrupteur (S3) connecté entre les moyens diviseurs de fréquence (6, 7) et une autre borne d'entrée du comparateur de phase (3); et

des moyens pour commander les caractéristiques temporelles de fermeture/ouverture de l'interrupteur d'alimentation (Sp), du premier interrupteur (S2) et du second interrupteur (S3), de façon qu'à un instant auquel l'interrupteur d'alimentation (Sp) est dans l'état fermé, la fréquence de référence ($f_r$) et la fréquence de comparaison ($f_p$) soient appliquées au comparateur de phase (3) avec des phases égalisées.

2. Un synthétiseur de fréquence selon la revendication 1, dans lequel le premier interrupteur (S2) et le second interrupteur (S3) sont fermés simultanément après la fermeture de l'interrupteur d'alimentation (Sp), et ils sont ouverts simultanément avant que l'interrupteur d'alimentation (Sp) ne soit ouvert.

3. Un synthétiseur de fréquence selon la revendication 1, dans lequel les moyens de génération de fréquence de référence (2) comprennent :

un oscillateur stabilisé par quartz (1) qui génère un multiple de rang M de la fréquence de référence ($f_r$), en désignant par M un nombre entier, et

un diviseur de fréquence de rang 1/M (2) qui divise par M la fréquence de sortie de l'oscillateur stabilisé par quartz.

4. Un synthétiseur de fréquence selon l'une des revendications 1 à 3, dans lequel les moyens diviseurs de fréquence comprennent :

un diviseur fixe de tête (6) qui est destiné à diviser par un entier P la fréquence de sortie ($f_{out}$) de l'oscillateur commandé par tension (5), l'énergie d'alimentation pour ce diviseur fixe de tête étant appliquée ou coupée par l'interrupteur d'alimentation (Sp); et

un diviseur de fréquence programmable (7) destiné à effectuer une division supplémentaire, par un entier variable N, de la fréquence de sortie du diviseur fixe de tête ($f_N$).

5. Un synthétiseur de fréquence selon l'une quelconque des revendications 1 à 4, comprenant en outre un second circuit de boucle de verrouillage de phase qui comprend :

un second comparateur de phase (8) qui est destiné à fournir un second signal de différence correspondant à la différence de phase entre la fréquence de référence ($f_r$) et la fréquence de comparaison ($f_p$);

un second filtre (9) qui est un filtre passe-bas connecté de façon à recevoir le second signal de différence, et à fournir une tension correspondant à la différence de phase entre la fréquence de référence ($f_r$) et la fréquence de comparaison ($f_p$);

un amplificateur opérationnel (10) qui est destiné à amplifier la tension de sortie du second filtre de boucle, et à la renvoyer vers des moyens oscillateurs à quartz commandés par tension (1-1);

un troisième interrupteur (S4), intercalé entre les moyens oscillateurs à quartz commandés par tension (1-1) et une borne d'entrée du second comparateur de phase (8); et

un quatrième interrupteur (S5), intercalé entre une autre borne d'entrée du second comparateur de phase (8) et la sortie des moyens diviseurs de fréquence (6, 7).

6. Un synthétiseur de fréquence selon la revendication 5, dans lequel :

les troisième et quatrième interrupteurs (S4 et S5) peuvent être commandés de façon à se fermer simultanément après la fermeture de l'interrupteur d'alimentation (Sp), et à s'ouvrir simultanément pendant que l'interrupteur d'alimentation (Sp) est dans l'état fermé; et

les premier et second interrupteurs (S2 et S3) sont commandés pour se fermer simultanément à l'instant de l'ouverture des troisième et quatrième interrupteurs, et à s'ouvrir simultanément pendant que l'interrupteur d'alimentation (Sp) est dans l'état fermé.

7. Un synthétiseur de fréquence selon la revendication 5, dans lequel les moyens oscillateurs à quartz commandés par tension comprennent :

un oscillateur à quartz commandé par tension (1-1) qui est destiné à générer un multiple de rang M de la fréquence de référence ($f_r$), en désignant par M un nombre entier, et

un diviseur de fréquence 1/M (2), qui est destiné à diviser par M la fréquence de sortie de l'oscillateur à quartz commandé par tension.

8. Un synthétiseur de fréquence selon l'une quelconque des revendications 1 à 4, comprenant en outre un second circuit de boucle de verrouillage de phase qui comprend :

un comparateur de phase (3) qui est utilisé en commun avec le premier circuit de boucle de verrouillage de phase;

un second filtre de boucle (9) qui est un filtre passe-bas connecté de façon à recevoir le signal de différence provenant du comparateur de phase (3), et à fournir une tension correspondant à la différence de phase entre la fréquence de référence ($f_r$) et la fréquence de comparaison ($f_p$);

un amplificateur opérationnel (10) destiné à amplifier la tension de sortie du second filtre de boucle, et à la renvoyer vers les moyens oscillateurs à quartz commandés par tension;

un premier interrupteur (S2) connecté entre les moyens oscillateurs à quartz commandés par tension (VCXO) et une borne d'entrée du comparateur de phase (3); et

un commutateur de changement de circuit (S1-1), connecté du côté de la sortie du comparateur de phase (3), pour commuter le signal de sortie du comparateur de phase vers le premier ou le second filtre de boucle (4 ou 9).

9. Un synthétiseur de fréquence selon la revendication 8, dans lequel :

les premier et second interrupteurs (S2 et S3) peuvent être commandés de façon à se fermer et à s'ouvrir simultanément, lorsque l'interrupteur d'alimentation (Sp) est dans l'état fermé; et

le commutateur de changement de circuit (S1-1) peut être commandé de façon à commuter vers le premier filtre de boucle (4) lorsque les premier et second interrupteurs sont dans l'état fermé, et à être ramené vers le second filtre de boucle (9) simultanément à l'ouverture des premier et second interrupteurs.

10. Un synthétiseur de fréquence selon la revendication 8, dans lequel les moyens oscillateurs à quartz commandés par tension comprennent :

un oscillateur à quartz commandé par tension (VCXO) (1-1) qui est destiné à générer un multiple de rang M de la fréquence de référence ($f_r$), en désignant par M un nombre entier, et

un diviseur de fréquence 1/M (2) qui est destiné à diviser par M la fréquence de sortie de l'oscillateur à quartz commandé par tension.

11. Un synthétiseur de fréquence selon l'une quelconque des revendications 1 à 4, comprenant en outre un circuit de commande automatique de phase (CAP) qui comprend :

un troisième comparateur de phase (11) dont une borne d'entrée est connectée aux moyens de génération de fréquence de référence par l'intermédiaire d'un cinquième interrupteur (S6), et dont une autre borne d'entrée est connectée, par l'intermédiaire d'un sixième interrupteur (S7), au second interrupteur (S3), du côté opposé à la connexion au premier comparateur de phase (3);

un filtre passe-bas (12) qui est destiné à recevoir le signal de sortie du troisième comparateur de phase et à fournir un signal de commande; et

un déphaseur variable (13) qui est intercalé entre les moyens diviseurs de fréquence et le second interrupteur (S3), ce déphaseur variable (13) pouvant être commandé par le signal de commande qui provient du filtre passe-bas (12).

12. Un synthétiseur de fréquence selon la redvendication 11, dans lequel :

les cinquième et sixième interrupteurs (S6 et S7) peuvent être commandés de façon à se fermer et à s'ouvrir simultanément lorsque l'interrupteur d'alimentation (Sp) est dans l'état fermé; et

les premier et second interrupteurs (S2 et S3) peuvent être commandés de façon à se fermer simultanément lorsque les cinquième et sixième interrupteurs sont dans l'état fermé, et à s'ouvrir simultanément après l'ouverture des cinquième et sixième interrupteurs, mais pendant que l'interrupteur d'alimentation (Sp) est toujours dans l'état fermé.

**Patentansprüche**

1. Freuqenzsynthetisierer mit einem Phasenverriegelungskreis (PLL) für intermittierenden Betrieb, mit:

   einer Referenzfrequenzerzeugungseinrichtung (1, 2) zum Erzeugen einer Referenzfrequenz ($f_r$);

   einem Phasenverriegelungsschaltkreis (PLL), der einen spannungsgesteuerten Oszillator (5) zum Liefern einer Ausgangsfrequenz ($f_{out}$) umfaßt;

   einer Frequenzteilereinrichtung (6, 7) zum Teilen der Ausgangsfrequenz durch eine ganze Zahl und zum Liefern einer Vergleichsfrequenz ($f_p$), welche nahe an der Referenzfrequenz ($f_r$) liegt;

   einem Phasenkomparator (3) zum Liefern eines Differenzsignales entsprechend einer Phasendifferenz zwischen der Differenzfrequenz ($f_r$) und der Vergleichsfrequenz ($f_p$);

   einem Schleifenfilter (4) zum Empfangen des Differenzsignales und zum Liefern eines Steuersignales, um die Ausgangsfrequenz des spannungsgesteuerten Oszillators zu steuern; und

   einem Stromversorgungsschalter (Sp) zum Ein- oder Ausschalten einer Stromversorgung für die Frequenzteilereinrichtung (6, 7), um diese zum intermittierenden Betrieb zu veranlassen;

   **gekennzeichnet** durch

   einen ersten Schalter (S2), der zwischen dem Referenzfrequenzoszillator (2) und einem Eingangsanschluß des Phasenkomparators (3) vorgesehen ist;

   einen zweiten Schalter (S3), der zwischen der Frequenzteilereinrichtung (6, 7) und einem anderen Eingangsanschluß des Phasenkomparators (3) vorgesehen ist; und

   Einrichtungen zum Steuern einer Ein-Aus-Zeitgebung des Stromversorgungsschalters (Sp), des ersten Schalters (S2) und des zweiten Schalters (S3), so daß zu einer Zeit, wenn sich der Stromversorgungsschalter (Sp) im Ein-Zustand befindet, die Referenzfrequenz ($f_r$) und die Vergleichsfrequenz ($f_p$) mit angeglichenen Phasen auf den Phasenkomparator (3) gegeben werden.

2. Frequenzsynthetisierer nach Anspruch 1, dadurch **gekennzeichnet,** daß der erste Schalter (S2) und der zweite Schalter (S3) gleichzeitig eingeschaltet werden, nachdem der Stromversorgungsschalter (Sp) eingeschaltet ist, und gleichzeitig ausgeschaltet werden, bevor der Stromversorgungsschalter (Sp) ausgeschaltet wird.

3. Frequenzsynthetisierer nach Anspruch 1, dadurch **gekennzeichnet,** daß die Referenzfrequenzerzeugungseinrichtung (2) umfaßt:

   einen quarzstabilisierten Oszillator (1), der ein Vielfaches M der Referenzfrequenz ($f_r$) erzeugt, wobei M eine ganze Zahl ist, und

   einen 1/M-Frequenzteiler (2), der die Ausgangsfrequenz des quarzstabilisierten Oszillators durch M teilt.

4. Frequenzsynthetisierer nach einem der Ansprüche 1 bis 3, dadurch **gekennzeichnet,** daß die Frequenzteilereinrichtung umfaßt:

   einen Vorteiler (6) zum Teilen der Ausgangsfrequenz ($f_{out}$) des spannungsgesteuerten Oszillators (5) durch eine ganze Zahl P, wobei Eingangsleistung für den Vorteiler durch den Stromversorgungsschalter (Sp) ein- oder ausgeschaltet wird; und

   einen programmierbaren Frequenzteiler (7) zum weiteren Teilen der Ausgangsfrequenz des Vorteilers ($f_N$) durch eine ganzzahlige Variable N.

5. Frequenzsynthetisierer nach einem der Ansprüche 1 bis 4, **gekennzeichnet** durch einen zweiten Phasenverriegelungsschaltkreis, welcher umfaßt:

   einen zweiten Phasenkomparator (8), um ein zweites Differenzsignal entsprechend einer Phasendifferenz zwischen der Referenzfrequenz ($f_r$) und der Vergleichsfrequenz ($f_p$) zu liefern;

   ein zweites Filter (9), welches ein Tiefpaßfilter ist, und geschaltet ist, das zweite Differenzsignal zu empfangen und eine Spannung entsprechend der Phasendifferenz zwischen der Referenzfrequenz ($f_r$) und der Vergleichsfrequenz ($f_p$) vorzusehen;

einen Operationsverstärker (10) zum Verstärken der Ausgangsspannung des zweiten Schleifenfilters, und um diese rückzuführen an die spannungsgesteuerte Quarzoszillatoreinrichtung (1-1);

einen dritten Schalter (S4), der zwischen der spannungsgesteuerten Quarzoszillatoreinrichtung (1-1) und einem Eingangsanschluß des zweiten Phasenkomparators (8) eingefügt ist; und

einen vierten Schalter (S5), der zwischen einen anderen Eingangsanschluß des zweiten Phasenkomparators (8) und den Ausgang der Frequenzteilereinrichtung (6, 7) eingefügt ist.

6. Frequenzsynthetisierer nach Anspruch 5, dadurch **gekennzeichnet,** daß

die dritten und vierten Schalter (S4 und S5) steuerbar sind, gleichzeitig eingeschaltet zu werden, nachdem der Stromversorgungsschalter (Sp) eingeschaltet ist, und gleichzeitig ausgeschaltet zu werden, während sich der Stromversorgungsschalter (Sp) im Einzustand befindet; und

die ersten und zweiten Schalter (S2 und S3) gesteuert werden, zu der Zeit gleichzeitig einzuschalten, wenn die dritten und vierten Schalter ausgeschaltet werden, und gleichzeitig auszuschalten, während der Stromversorgungsschalter (Sp) im Einzustand ist.

7. Frequenzsynthetisierer nach Anspruch 5, dadurch **gekennzeichnet,** daß die spannungsgesteuerte Quarzoszillatoreinrichtung umfaßt:

einen spannungsgesteuerten Quarzoszillator (1-1), um ein Vielfaches M der Referenzfrequenz ($f_r$) zu erzeugen, worin M ganzzahlig ist, und

einen 1/M-Frequenzteiler (2) zum Teilen der Ausgangsfrequenz des spannungsgesteuerten Quarzoszillators durch M.

8. Frequenzsynthetisierer nach einem der Ansprüche 1 bis 4, **gekennzeichnet** durch einen zweiten PLL-Schaltkreis, welcher umfaßt:

einen Phasenkomparator (3), der gemeinsam mit dem ersten PLL-Schaltkreis verwendet wird;

ein zweites Schleifenfilter (9), das ein Tiefpaßfilter ist, und geschaltet ist, das Differenzsignal von dem Phasenkomparator (3) zu empfangen und eine Spannung entsprechend der Phasendifferenz zwischen der Referenzfrequenz ($f_r$) und der Vergleichsfrequenz ($f_p$) zu liefern;

einen Operationsverstärker (10) zum Verstärken der Ausgangsspannung des zweiten Schleifenfilters, und um diese an die spannungsgesteuerte Quarzoszillatoreinrichtung rückzuführen;

einen ersten Schalter (S2), der zwischen der spannungsgesteuerten Quarzoszillatoreinrichtung (VCXO) und einem Eingangsanschluß des Phasenkomparators (3) vorgesehen ist; und

einen Schaltkreiswechselschalter (S1-1), der auf der Ausgangsseite des Phasenkomparators (3) vorgesehen ist, um das Ausgangssignal des Phasenkomparators auf das erste oder zweite Schleifenfilter (4 bis 9) zu schalten.

9. Frequenzsynthetisierer nach Anspruch 8, dadurch **gekennzeichnet,** daß

die ersten und zweiten Schalter (S2 und S3) steuerbar sind, gleichzeitig ein- und ausgeschaltet zu werden, wenn sich der Stromversorgungsschalter (Sp) in dem Einzustand befindet; und

der Schaltkreiswechselschalter (S1-1) steuerbar ist, auf das erste Schleifenfilter (4) umzuschalten, wenn die ersten und zweiten Schalter im Einzustand sind, und zur gleichen Zeit zurück zum zweiten Schleifenfilter (9) geschaltet zu werden, wenn die ersten und zweiten Schalter ausgeschaltet werden.

10. Frequenzsynthetisierer nach Anspruch 8, dadurch **gekennzeichnet,** daß die spannungsgesteuerte Quarzoszillatoreinrichtung umfaßt:

einen spannungsgesteuerten Quarzoszillator (VCXO) (1-1) zum Erzeugen eines Vielfachen M der Referenzfrequenz ($f_r$), worin M ganzzahlig ist, und

einen 1/M-Frequenzteiler (2) zum Teilen der Ausgangsfrequenz des spannungsgesteuerten Quarzoszillators durch M.

11. Frequenzsynthetisierer nach einem der Ansprüche 1 bis 4,
**gekennzeichnet** durch einen automatischen Phasenregelungsschaltkreis (APC), welcher umfaßt:

einen dritten Phasenkomparator (11), von dem ein Eingangsanschluß mit der Referenzfrequenzerzeugungseinrichtung über einen fünften Schalter (S6) verbunden ist, und ein anderer Eingangsanschluß über einen sechsten Schalter (S7) mit dem zweiten Schalter (S3) auf der Seite entgegengesetzt zu der Verbindung mit dem ersten Phasenkomparator (3) verbunden ist;

ein Tiefpaßfilter (2) zum Empfangen des Ausganges des dritten Phasenkomparators, und zum Liefern eines Steuersignales; und

einen variablen Phasenschieber (13), der zwischen die Frequenzteilereinrichtung und den zweiten Schalter (S3) eingefügt ist, wobei der variable Phasenschieber (13) steuerbar ist von dem Steuerungssignal von dem Tiefpaßfilter (12).

12. Frequenzsynthetisierer nach Anspruch 11, dadurch **gekennzeichnet,** daß

die fünften und sechsten Schalter (S6 und S7) steuerbar sind, gleichzeitig ein- und ausgeschaltet zu werden, wenn sich der Stromversorgungsschalter (Sp) im Einzustand befindet; und

die ersten und zweiten Schalter (S2 und S3) steuerbar sind, gleichzeitig eingeschaltet zu werden, wenn sich die fünften und sechsten Schalter im Einzustand befinden, und gleichzeitig ausgeschaltet zu werden, nachdem die fünften und sechsten Schalter ausgeschaltet sind, jedoch während der Stromversorgungsschalter (Sp) noch im Einzustand ist.

## FIG.1

## FIG.2

(A) $S_p, S_1$  ON  OFF

time

(B) variation of $f_{out}$

tolerance of frequency shift

## FIG.3

(A) $f_r$

(B) $S_p, S_1$  ON  OFF

State 1    State 2    State 3

a

(C) $f_p$

b    c    time

(D) output of phase comparator 3

FIG.4

FIG.5

FIG.6

## FIG.7

## FIG.8

(A) $S_p$  ON / OFF

(B) $S_4, S_5$  ON / OFF

(C) $S_2, S_3$  ON / OFF

(D) $f_0$

(E) $f_{out}$

time

tolerance of frequency shift

# FIG.9

# FIG.10

## FIG . 11

## FIG . 12